# EUROPEAN PATENT APPLICATION

(11) **EP 4 675 298 A2**
(43) Date of publication of application: **07.01.2026**
(21) Application number: 25185498.0
(22) Date of filing: 26.06.2025
(51) Int. Cl.: G01R 33/00, G01D 5/14, G01R 33/07, G01R 33/09

(54) **OFF-AXIS MAGNETIC FIELD SENSOR**

(30) Priority: 02.07.2024 IN 202411050558; 23.06.2025 US 202519246570
(71) Applicant: Honeywell International Inc., Charlotte, NC 28202 (US)
(72) Inventor: SANCHIHAR, Paresh, Charlotte, 28202 (US)
(74) Representative: Haseltine Lake Kempner LLP

(57) **Abstract**

A sensor assembly comprising a printed circuit board assembly (PCBA) housing that is configured horizontally or in parallel with a planar surface of a magnet. The PCBA housing comprises a PCBA that is deposed within a cavity of the PCBA housing. The PCBA comprises a pair of magnetic field sensors that (i) are oriented horizontally with respect to the planar surface of the magnet and (ii) comprises a first magnetic field sensor of the pair of magnetic field sensors that is configured a predetermined distance from a second magnetic field sensor of the pair of magnetic field sensors, wherein the pair of magnetic field sensors are configured to generate a respective pair of electrical signals that comprise a phase-shift between the respective pair of electrical signals proportional to the predetermined distance.

## Description

### CROSS REFERENCE TO RELATED APPLICATION

This application claims the priority of IN Provisional Application No. 202411050558, entitled "OFF-AXIS MAGNETIC FIELD SENSOR," filed on July 2, 2024, the disclosure of which is hereby incorporated by reference in its entirety.

### TECHNICAL FIELD

Various embodiments of the present disclosure relate to a magnetic field sensor, and more particularly to a planar magnetic field sensor assembly that interfaces with a spiraled multipole magnet.

### BACKGROUND

Some existing designs of resolvers comprise a sensor package that houses both (i) a vertically mounted magnetic field sensor that is perpendicular to a planar surface of a magnet and (ii) a horizontally mounted magnetic field sensor that is parallel to the planar surface of the magnet. As such, a sensor package used in such resolvers often comprises a vertical printed circuit board assembly (PCBA) for a vertically mounted magnetic field sensor and a horizontal PCBA for a horizontally mounted magnetic field sensor, thereby resulting in a sensor package that is larger, heavier, or bulkier than desired. Additionally, a vertically mounted magnetic field sensor may limit configuration of an airgap between a magnet and the vertically mounted magnetic field to approximately 1-2 mm in order to achieve a desired accuracy. Applicant has identified disadvantages associated with conventional resolvers.

### BRIEF SUMMARY

Various embodiments described herein relate to components, apparatuses, and systems for measuring magnetic fields.

In accordance with various embodiments of the present disclosure, a sensor assembly is provided. In some embodiments, the sensor assembly comprises a printed circuit board assembly (PCBA) housing that is configured horizontally or in parallel with a planar surface of a magnet. In some embodiments, the PCBA housing comprises a PCBA that is deposed within a cavity of the PCBA housing. In some embodiments, the PCBA comprises a pair of magnetic field sensors. In some embodiments, the pair of magnetic field sensors (i) are oriented horizontally with respect to the planar surface of the magnet and (ii) comprises a first magnetic field sensor of the pair of magnetic field sensors that is configured a predetermined distance from a second magnetic field sensor of the pair of magnetic field sensors. In some embodiments, the pair of magnetic field sensors are configured to generate a respective pair of electrical signals that comprise a phase-shift between the respective pair of electrical signals proportional to the predetermined distance.

In some embodiments, the magnet comprises a plurality of magnetic poles that are oriented in a plurality of radial spiral shapes. In some embodiments, the plurality of radial spiral shapes provides variance in one or more magnetic fields that are induced by the plurality of magnetic poles on the pair of magnetic field sensors upon causing a rotational displacement between the plurality of magnetic poles and the pair of magnetic field sensors. In some embodiments, the pair of magnetic field sensors are configured to generate the respective pair of electrical signals based on a variance in one or more magnetic fields that are induced on the pair of magnetic field sensors. In some embodiments, the variance is provided by rotational movement of the PCBA housing relative to one or more magnetic poles that are associated with the magnet. In some embodiments, the respective pair of electrical signals comprise oscillating patterns. In some embodiments, the oscillating patterns are representative of a position of the magnet or relative to the magnet.

According to some embodiments, a measurement subsystem is provided. In some embodiments, the measurement subsystem comprises one or more PCBAs that are positioned horizontally or in parallel with a planar surface of a magnet. In some embodiments, a PCBA of the one or more PCBAs comprise a first magnetic field sensor and a second magnetic field sensor. In some embodiments, the first magnetic field sensor and the second magnetic field sensor are configured to (i) detect or measure one or more magnetic fields in either a radial or tangential direction with respect to the planar surface of the magnet and (ii) generate a first electrical signal and a second electrical signal based on the one or more magnetic fields.

In some embodiments, the first magnetic field sensor is configured at a predetermined angular distance from the second magnetic field sensor. In some embodiments, the first magnetic field sensor and the second magnetic field sensor are configured on the PCBA such that the first electrical signal and the second electrical signal comprise a phase-shift between the first electrical signal and the second electrical signal and that the first electrical signal and the second electrical signal comprise sine and cosine waves based on a number of magnetic poles of the magnet. In some embodiments, the magnet comprises at least a north magnetic pole track and a south magnetic pole track that are oriented in respective radial spiral shapes. In some embodiments, the radial spiral shapes cause a rotating magnetic field in sine and cosine waveform that comprise voltage outputs at the first magnetic field sensor and the second magnetic field sensor based on rotational displacement between (i) the at least one north magnetic pole track and the south magnetic pole tracks and (ii) the first magnetic field sensor and the second magnetic field sensor about a common axis. In some embodiments, the rotational displacement is caused by rotating either the magnet or the PCBA. In some embodiments, the first electrical signal and the second electrical signal comprise respective sine and cosine patterns based on the radial spiral shapes. In some embodiments, the first magnetic field sensor and the second magnetic field sensor are configured to generate the first electrical signal and the second electrical signal based on a rotational position of the magnet with respect to the first magnetic field sensor and the second magnetic field sensor. In some embodiments, the first electrical signal and the second electrical signal are associated with an angle, speed, direction, or linear position. In some embodiments, at least one of the first magnetic field sensor or the second magnetic field sensor comprises a magneto-resistive (MR) Wheatstone bridge circuit. In some embodiments, the MR Wheatstone bridge circuit comprises two interleaved or overlaid MR Wheatstone bridges that are associated with respective ones of the first magnetic field sensor and the second magnetic field sensor. In some embodiments, the first magnetic field sensor and the second magnetic field sensor are oriented either horizontally or vertically with respect to the planar surface of the magnet. In some embodiments, the first magnetic field sensor and the second magnetic field sensor comprise one-directional sensors.

The foregoing illustrative summary, as well as other exemplary objectives and/or advantages of the disclosure, and the manner in which the same are accomplished, are further explained in the following detailed description and its accompanying drawings.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1 is a perspective view of an example sensor assembly in accordance with some embodiments of the present disclosure;
FIG. 2 is a top view of example measurement subsystem in accordance with some embodiments of the present disclosure;
FIG. 3 is a cross-sectional side view of at least a portion of an example measurement subsystem in accordance with some embodiments of the present disclosure;
FIG. 4 is a schematic diagram of an example magnetic field sensor circuit in accordance with some embodiments of the present disclosure;
FIG. 5 is a top view of an example magnetic field sensor configuration in accordance with some embodiments of the present disclosure;
FIG. 6 is a top view of an example magnetic field sensor configuration in accordance with some embodiments of the present disclosure;
FIG. 7 is a top view of an example magnetic field sensor configuration in accordance with some embodiments of the present disclosure;
FIG. 8 is a graph of example magnetic field sensor signal outputs of a measurement device in accordance with some embodiments of the present disclosure;
FIG. 9A is a cross-sectional side view of at least a portion of an existing measurement subsystem 900A; and
FIG. 9B is a cross-sectional side view of at least a portion of an existing measurement subsystem 900B in accordance with some embodiments of the present disclosure.
FIG. 10A is a top view of an example two redundant output planar configuration in accordance with some embodiments of the present disclosure.
FIG. 10B is a top view of an example three redundant output planar configuration in accordance with some embodiments of the present disclosure.
FIG. 11 is an example angular positioning of sensors in an example four redundant output planar configuration of a measurement subsystem in accordance with some embodiments of the present disclosure.
FIG. 12 is a perspective view of an example three sensor tandem redundancy configuration of a measurement subsystem in accordance with some embodiments of the present disclosure.

### DETAILED DESCRIPTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," etc., are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

As described above, there are many technical challenges and difficulties that are associated with some existing designs of resolvers. In particular, some existing resolvers may comprise magnetic field sensors that are oriented in two distinct axes that allow for magnetic field readings of a magnet, such as a spiraled multipole magnet, in two-dimensions to generate simultaneous sinusoidal (e.g., sine and cosine) signal outputs when displacement between the magnetic poles of the magnet and the magnetic field sensors is varied. For example, some existing resolvers may comprise (i) a first magnetic field sensor that is configured vertically with respect to a plane of a magnet and (ii) a second magnetic field sensor that is configured horizontally with respect to the plane of the magnet. Accordingly, a vertically configured magnetic field sensor and a horizontally configured magnetic field sensor may be mounted on a vertically configured printed circuit board assembly (PCBA) and a horizontally configured PCBA, respectively, within a sensor package, thereby resulting in a relatively large sensor package footprint that is overly complicated, heavy, and performance-constrained. Additionally, a resolver that comprises both vertically configured and horizontally configured PCBAs may constrain the resolver's design with respect to thickness and dimensions, which may impact accuracy, thereby limiting the resolver's usefulness to a narrow range of applications. That is, a variety of applications may require larger ranges of airgap that some existing resolvers (e.g., comprising both vertically and horizontally configured magnetic field sensor and/or PCBA) are unable to provide.

Various example embodiments of the present disclosure overcome such technical challenges and difficulties in resolvers and provide various technical advancements and improvements. In accordance with various embodiments of the present disclosure, example resolver components for improving performance and design constraints are disclosed.

In some embodiments, a resolver refers to a rotary electrical transformer that may be used for measuring degrees of rotation, such as rotation angular position of mechanical or electrical components. In some embodiments, a resolver may comprise an electromagnetic transducer that is configured to convert angular position or motion to an analog or digital signal by measuring a magnetic field of a magnet. Accordingly, in some embodiments, a resolver may be configured to generate electrical signals via one or more magnetic field sensors that are configured to detect and/or measure varying magnetic fields caused by a change in rotational position/displacement between poles of the magnet and the one or more magnetic field sensors.

In some embodiments, a magnetic field sensor may comprise any type of sensor that is configured to detect and/or measure a magnetic field. For example, a magnetic field sensor may comprise a Hall-effect sensor, an anisotropic magneto resistance (AMR) sensor, a giant magnetoresistance (GMR) sensor, or a tunnel magnetoresistance (TMR) sensor.

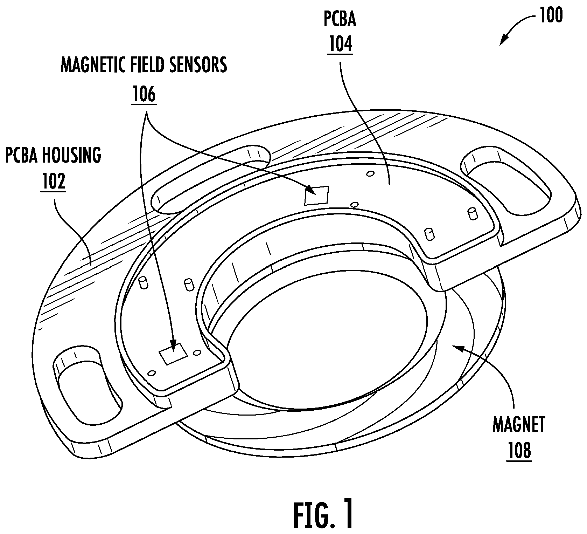

Referring now to FIG. 1, a perspective view of an example sensor assembly 100 is provided in accordance with some embodiments of the present disclosure. As depicted in FIG. 1, the sensor assembly 100 comprises a PCBA housing 102 that is configured (substantially) horizontally and/or in parallel with a planar surface of magnet 108. The PCBA housing 102 comprises a PCBA 104 that is deposed within a cavity of the PCBA housing 102. The PCBA 104 comprises a pair of magnetic field sensors 106 that are oriented horizontally with respect to the planar surface of the magnet 108. In some embodiments, the pair of magnetic field sensors 106 are configured to generate a respective pair of electrical signals based on one or more magnetic fields induced by magnet 108. The pair of magnetic field sensors 106 may be configured to detect and/or measure magnetic fields in one or more directions (e.g., radial or tangential) with respect to the planar surface of the magnet 108. According to various embodiments of the present disclosure, the pair of magnetic field sensors 106 are configured a predetermined distance from each other (e.g., a first magnetic field sensor of the pair of magnetic field sensors is configured a predetermined distance from a second magnetic field sensor of the pair of magnetic field sensors) such that the pair of magnetic field sensors 106 are caused to generate a respective pair of electrical signals that comprise a phase-shift between the respective pair of electrical signals proportional to the predetermined distance.

In some embodiments, the PCBA housing 102 is configured over at least a portion of the magnet 108 such that an airgap of a predetermined size is created between the pair of magnetic field sensors 106 and the magnet 108. In some embodiments, the magnet 108 comprises a plurality of magnetic poles that are oriented in a plurality of uniformly repeating radial spiral shapes. In some embodiments, the radial spiral shapes of the magnetic poles allow for variance in the magnetic fields induced by the magnetic poles on the pair of magnetic field sensors 106 upon causing a rotational displacement between the magnetic poles of the magnet 108 and the pair of magnetic field sensors 106. For example, the PCBA housing 102 and the magnet 108 may share a common axis in which the PCBA housing 102 or the magnet 108 may independently and/or individually revolve about. As such, a variance in the magnetic fields induced on the pair of magnetic field sensors 106 may be provided by rotational movement of the PCBA housing 102 relative to the magnetic poles of the magnet 108, which in turn may cause the pair of magnetic field sensors 106 to generate a respective pair of electrical signals that comprise oscillating patterns (e.g., sinusoidal signals). In some embodiments, the oscillating patterns of the electrical signals generated by the pair of magnetic field sensors 106 may be representative of (or used to determine) a position (e.g., angular or rotational) of the magnet 108 or relative to the magnet 108.

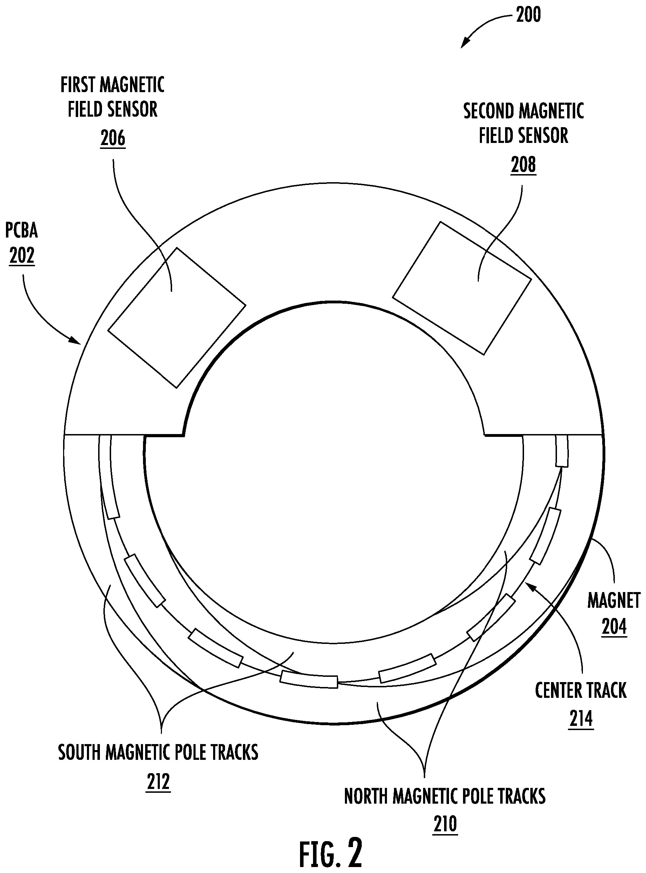

FIG. 2 is a top view of example measurement subsystem 200 in accordance with some embodiments of the present disclosure. As depicted in FIG. 2, the measurement subsystem 200 comprises a PCBA 202 that is positioned (substantially) horizontally and/or in parallel with a planar surface of a magnet 204. The PCBA 202 comprises a first magnetic field sensor 206 and a second magnetic field sensor 208 that are configured on a planar surface of the PCBA 202 and oriented horizontally with respect to the planar surface of the magnet 204. In some embodiments, the first magnetic field sensor 206 and the second magnetic field sensor 208 are configured to detect and/or measure magnetic fields in one or more directions (e.g., radial or tangential) with respect to the planar surface of the magnet 204. According to various embodiments of the present disclosure, the first magnetic field sensor 206 and the second magnetic field sensor 208 are configured on the PCBA 202 based on a configuration of magnetic poles on the magnet 204. For example, the first magnetic field sensor 206 is configured at a predetermined angular distance from the second magnetic field sensor 208 on the planar surface of PCBA 202 based on the magnet 204 comprising north magnetic pole tracks 210 and south magnetic pole tracks 212. In some embodiments, the first magnetic field sensor 206 and the second magnetic field sensor 208 are configured on the PCBA 202 (e.g., an angular distance from each other) such that respective electrical signals generated by the first magnetic field sensor 206 and the second magnetic field sensor 208 comprise a desired phase-shift between the respective electrical signals.

The magnet 204 comprises north magnetic pole tracks 210 and south magnetic pole tracks 212 that are oriented in complementary radial spiral shapes, off-axis from the center track 214, thereby forming a spiraled multipole magnet. The PCBA 202 and the magnet 204 may share a common axis in which the PCBA 202 or the magnet 204 may independently and/or individually revolve about. As such, the radial spiral shapes of the north magnetic pole tracks 210 and the south magnetic pole tracks 212 may induce variable respective magnetic fields at the first magnetic field sensor 206 and the second magnetic field sensor 208 upon rotational displacement between the magnetic pole tracks (the north magnetic pole tracks 210 and the south magnetic pole tracks 212) and the magnetic field sensors (the first magnetic field sensor 206 and the second magnetic field sensor 208) about the common axis. In some embodiments, a rotational displacement between the magnetic pole tracks (north magnetic pole tracks 210 and south magnetic pole tracks 212) and the magnetic field sensors (first magnetic field sensor 206 and second magnetic field sensor 208) may be caused by rotating either the magnet 204 or the PCBA 202 thereby causing magnetic fields induced by the north magnetic pole tracks 210 and the south magnetic pole tracks 212 on the first magnetic field sensor 206 and the second magnetic field sensor 208 to change with rotational displacement. As such, the first magnetic field sensor 206 and the second magnetic field sensor 208 may generate electrical signals that comprise patterns based on the radial spiral shapes of the north magnetic pole tracks 210 and the south magnetic pole tracks 212. In some example embodiments, the radial spiral shapes of the north magnetic pole tracks 210 and the south magnetic pole tracks 212 may enable the first magnetic field sensor 206 and the second magnetic field sensor 208 (e.g., configured at a predetermined angular distance from each other) to each generate electrical (e.g., sine and cosine) signals that are associated with a rotational position of the magnet 204 with respect to the first magnetic field sensor 206 and the second magnetic field sensor 208. In some embodiments, the electrical signals may be associated with and used to extract an angle, speed, direction, or linear position of the magnet 204 (e.g., absolute or relative to the PCBA 202, the first magnetic field sensor, and/or the second magnetic field sensor).

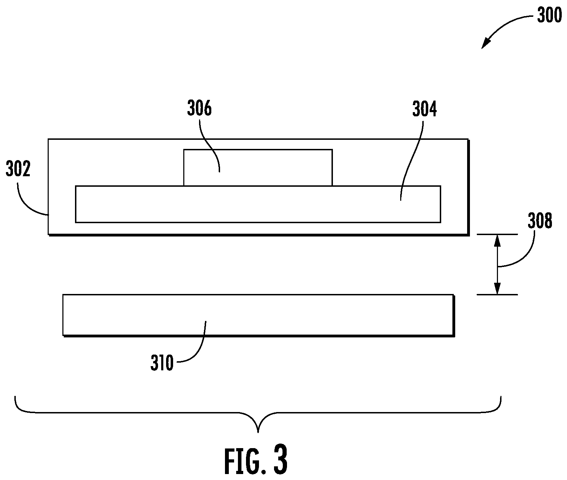

FIG. 3 is a cross-sectional side view of at least a portion of an example measurement subsystem 300 in accordance with some embodiments of the present disclosure. The measurement subsystem 300 may be an example of the sensor assembly 100 of FIG. 1 or the measurement subsystem 200 of FIG. 2. As depicted in FIG. 3, a portion of the example measurement subsystem 300 comprises a PCBA housing 302 that is (substantially) horizontally and/or parallelly interfaced or configured with a planar surface of a magnet 310. FIG. 3 further depicts that the PCBA housing 302 comprises a PCBA 304 and a magnetic field sensor 306 that is embedded on the surface of the PCBA 304 in an orientation that is horizontal to the planar surface of the magnet 310. An air gap 308 is maintained between the PCBA housing 302 and the magnet 310. According to various embodiments of the present disclosure, the air gap 308 may comprise a distance that is within a range (e.g., approximately 1.5mm to 8mm) that is greater than that of some aforementioned existing resolvers (e.g., approximately 1mm to 1.5mm). The larger range of the air gap 308 may be afforded by the magnetic field sensor 306 being horizontally oriented on the surface of the PCBA 304.

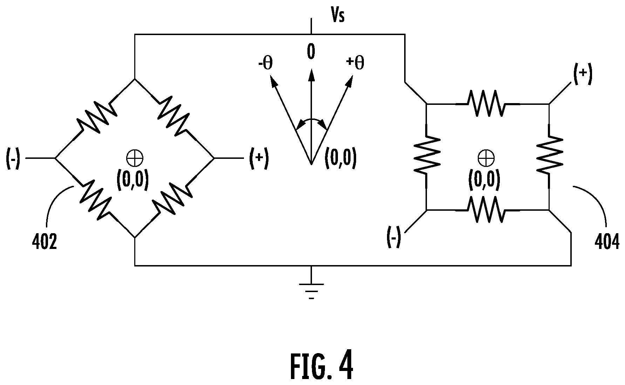

FIG. 4 is a schematic diagram of an example magnetic field sensor circuit 400 in accordance with some embodiments of the present disclosure. According to various embodiments of the present disclosure, magnetic field sensors of a measurement subsystem may be configured in a magneto-resistive (MR) Wheatstone bridge circuit, such as magnetic field sensor circuit 400. As depicted in FIG. 4, the magnetic field sensor circuit 400 comprises two interleaved or overlaid MR Wheatstone bridges 402 and 404 (each corresponding to a magnetic field sensor). The two MR Wheatstone bridges 402 and 404 may be offset by a predetermined angular distance along a track (e.g., with respect to a magnet) such that the differential signals of two MR Wheatstone bridges 402 and 404 (e.g., via comparators or operational amplifiers) may provide separate sine and cosine electrical (e.g., voltage) signals (e.g., signals that are phase shifted by 90 degrees). For example, a periodic sine or cosine signal may be independently generated by each of the two MR Wheatstone bridges 402 and 404 as a result of rotational displacement of the MR Wheatstone bridges 402 and 404 relative to magnetic poles of a multipole magnet. Accordingly, signals generated by the magnetic field sensor circuit 400 may comprise redundant outputs which may provide redundancy, reliability, and health monitoring features.

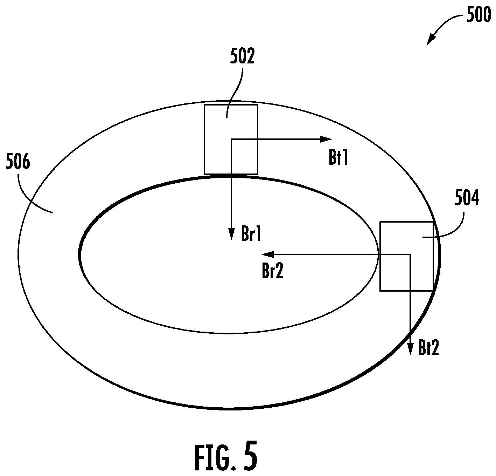

FIG. 5 is a top view of an example magnetic field sensor configuration 500 in accordance with some embodiments of the present disclosure. The magnetic field sensor configuration 500 comprises a first magnetic field sensor 502 and a second magnetic field sensor 504 that are configured over respective surface plane locations on the magnet 506. According to various embodiments of the present disclosure, the first magnetic field sensor 502 and the second magnetic field sensor 504 may comprise two-directional sensors that are configured (e.g., a horizontal sensor PCB and a vertical sensor PCB) to detect and/or measure magnetic fields in both radial field and tangential field directions. For example, the first magnetic field sensor 502 may detect and/or measure magnetic fields along either the Br1 or Bt1 axes and the second magnetic field sensor 504 may detect and/or measure magnetic fields along either the Br2 or Bt2 axes. As such, the first magnetic field sensor 502 and the second magnetic field sensor 504 may generate electrical (e.g., voltage) signals (e.g., sine and cosine) from magnetic fields induced along Br1 and Br2 or Bt1 and Bt2.

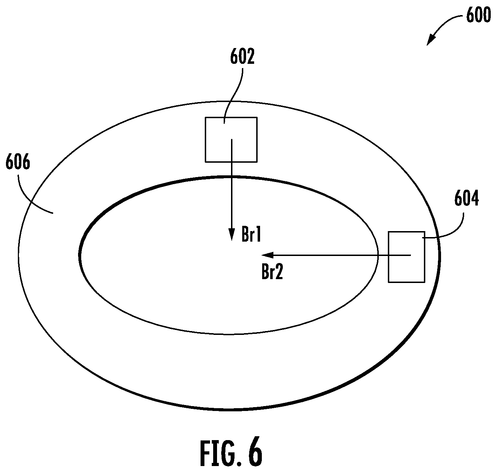

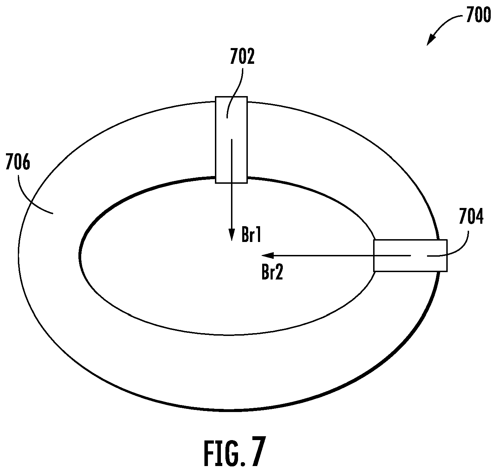

According to some embodiments, magnetic fields induced by, for example, radially spiral-shaped magnetic poles of a spiraled multipole magnet, on the radial field axes may facilitate generation of signals by the first magnetic field sensor 502 and the second magnetic field sensor 504 that are more sinusoidal then on the tangential field axes. Thus, in some embodiments, magnetic field sensors may comprise one-directional sensors that are configured to detect and/or measure magnetic fields in a direction of the radial field axes (e.g., Br1 and Br2) and generate electrical signals based thereof, as shown in FIG. 6 and FIG. 7 to achieve sine and cosine signals with better accuracy. Accordingly, by detecting and/or measuring on the radial field axes, magnetic field sensors used in some embodiments of the present disclosure may be unaffected by airgap variation (in the vertical direction).

FIG. 6 is a top view of an example magnetic field sensor configuration 600 in accordance with some embodiments of the present disclosure. The magnetic field sensor configuration 600 comprises a first magnetic field sensor 602 and a second magnetic field sensor 604 that are configured horizontally over respective surface plane locations on the magnet 606. In some embodiments, the first magnetic field sensor 602 and the second magnetic field sensor 604 comprise one-directional sensors that are configured to detect and/or measure magnetic fields induced in a radial direction (Br1 and Br2) and generate electrical signals based thereof.

FIG. 7 is a top view of an example magnetic field sensor configuration 700 in accordance with some embodiments of the present disclosure. The magnetic field sensor configuration 700 comprises a first magnetic field sensor 702 and a second magnetic field sensor 704 that are configured vertically over respective surface plane locations on the magnet 706. In some embodiments, the first magnetic field sensor 702 and the second magnetic field sensor 704 comprise one-directional sensors that are configured to detect and/or measure magnetic fields induced in a radial direction (Br1 and Br2) and generate electrical signals based thereof.

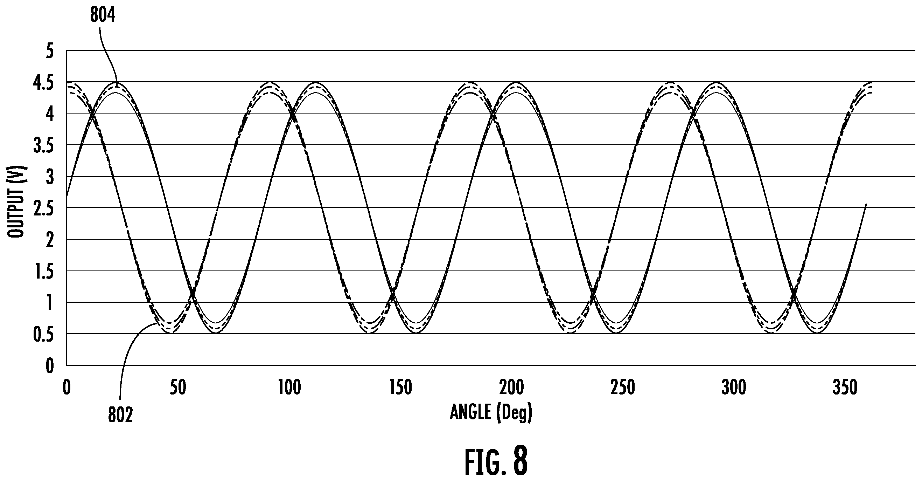

FIG. 8 is a graph of example magnetic field sensor signal outputs of a measurement device in accordance with some embodiments of the present disclosure. As depicted in FIG. 8, voltage output values of a first signal 802 and a second signal 804 are plotted against angle. The first signal 802 may be generated by a first magnetic field sensor and the second signal 804 may be generated by a second magnetic field sensor. The output values of the first signal 802 and the second signal 804 may be based on detected/measured magnetic field strength or flux (by a first magnetic field sensor and a second magnetic field sensor, respectively). The angles of the first signal 802 and the second signal 804 may be associated with angular position with respect to a magnet (e.g., rotated about a common axis shared by the magnet and a first magnetic field sensor and a second magnetic field sensor generating the first signal 802 and the second signal 804, respectively). In some embodiments, the first signal 802 is associated with a magnetic field measurement of one or more first poles and the second signal 804 is associated with a magnetic field measurement of one or more second poles. The first signal 802 and the second signal 804 may comprise a relative phase-shift that is based on an angular distance between associated magnetic field sensors generating the first signal 802 and the second signal 804.

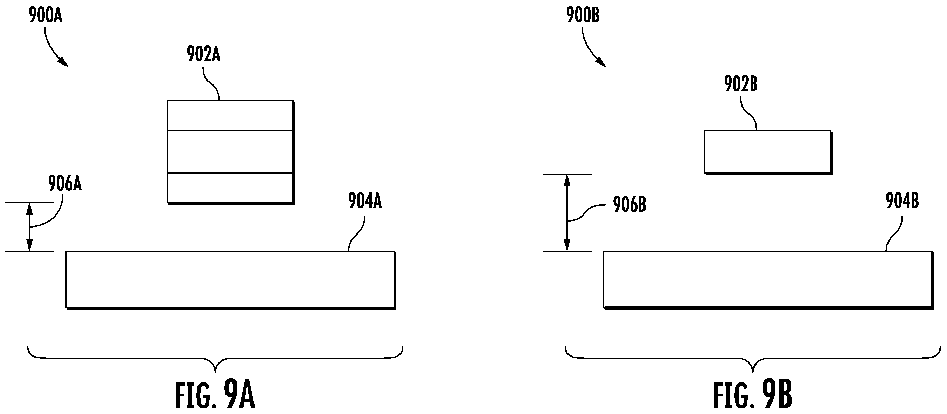

FIG. 9A is a cross-sectional side view of at least a portion of a measurement subsystem 900A. As depicted in FIG. 9A, the measurement subsystem 900A comprises a sensor package 902A that is configured above a magnet 904A with an airgap 906A. The sensor package 902A comprises both (i) a vertically mounted magnetic field sensor that is perpendicular to a planar surface of a magnet 904A and (ii) a horizontally mounted magnetic field sensor that is parallel to the planar surface of the magnet 904A. As such, the sensor package 902A is limited by the sensor package 902A comprising both vertical and horizontal magnetic field sensors such that the airgap 906A may be limited to within a range of 1 to 1.5mm.

FIG. 9B is a cross-sectional side view of at least a portion of a measurement subsystem 900B in accordance with some embodiments of the present disclosure. As depicted in FIG. 9B, the measurement subsystem 900B comprises a sensor package 902B that is configured above a magnet 904B with an airgap 906B. The sensor package 902B comprises a single horizontally mounted magnetic field sensor that is parallel to the planar surface of the magnet 904B. According to various embodiments of the present disclosure, the air gap 906B may comprise a distance that is within a range (e.g., approximately 1.5mm to 8mm) which is greater than that of air gap 906A. The larger range of the air gap 906B may be afforded by the sensor package 902B comprising a magnetic field sensor horizontally oriented with respect to a surface of magnet 904B, as disclosed herewith.

As disclosed herewith, the number of magnetic fields sensors in a magnetic field sensor configuration may be varied and scaled along with the number of magnetic poles to provide redundancy capabilities. For example, two or more sensors (or sensor pairs) may be used in parallel to measure a same parameter or provide duplicative outputs based on a same target, that ensure system reliability and/or safety in case of a single sensor failure. Redundancy may be used in applications, such as in aerospace or transportation where multiple outputs may be provided simultaneously, or where output of a sensor may be used on multiple applications in control systems.

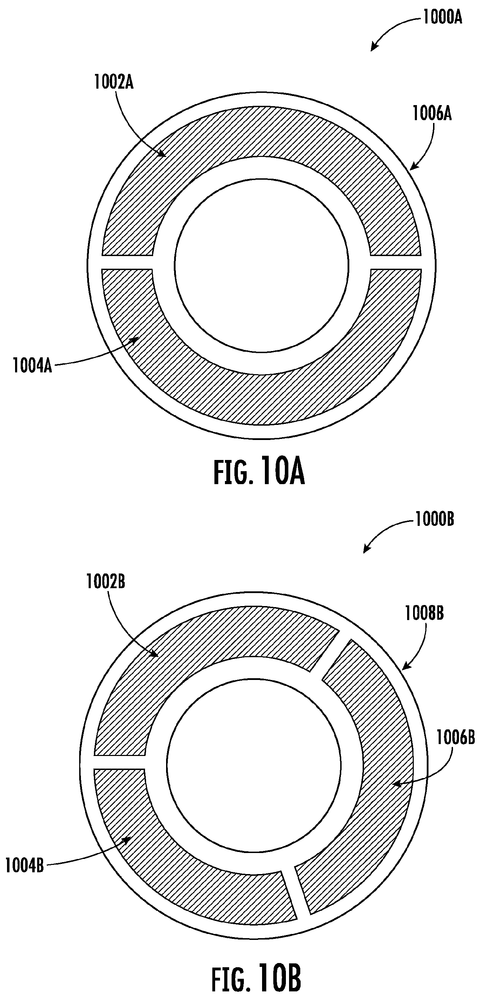

FIG. 10A is a top view of an example two redundant output planar configuration 1000A in accordance with some embodiments of the present disclosure. The two redundant output planar configuration 1000A comprises two sensor PCBAs 1002A and 1004A. Each of the sensor PCBAs 1002A and 1004A comprises a semi-annulus form factor and is configured on a same plane above a planar surface of a rotor 1006A. The sensor PCBAs 1002A and 1004A may each comprise one or more magnetic field sensors that are oriented horizontally with respect to the planar surface of the rotor 1006A. The sensor PCBAs 1002A and 1004A may be identical and/or substantially similar in shape and/or functionality. Furthermore, the sensor PCBAs 1002A and 1004A may each generate a redundancy output (e.g., that measures a same parameter but provides its own independent signal) when displaced from magnetic poles of a spiral-shaped magnet caused by rotation of the rotor 1006A.

FIG. 10B is a top view of an example three redundant output planar configuration 1000B in accordance with some embodiments of the present disclosure. Similar to the two redundant output planar configuration 1000A, the three redundant output planar configuration 1000B comprises three sensor PCBAs 1002B, 1004B, and 1006B. Each of the sensor PCBAs 1002B, 1004B, and 1006B comprises a semi-annulus form factor and is configured on a same plane above a planar surface of a rotor 1008B. The sensor PCBAs 1002B, 1004B, and 1006B may each comprise one or more magnetic field sensors that are oriented horizontally with respect to the planar surface of the rotor 1008B. The sensor PCBAs 1002B, 1004B, 1006B may also be identical and/or substantially similar in shape and/or functionality. The sensor PCBAs 1002B, 1004B, and 1006B may each generate a redundancy output (e.g., that measures a same parameter but provides its own independent signal) when displaced from magnetic poles of a spiral-shaped magnet caused by rotation of the rotor 1008B.

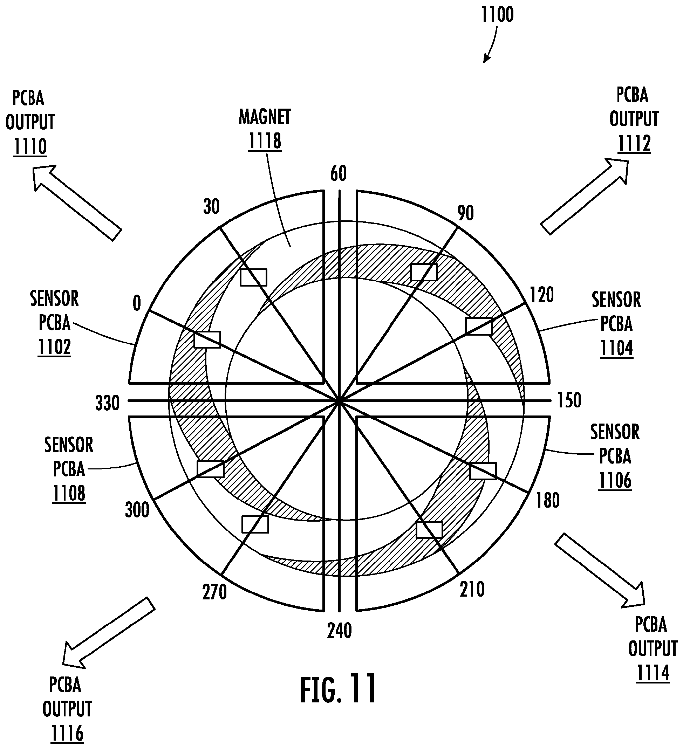

FIG. 11 is an example angular positioning of sensors in an example four redundant output planar configuration of a measurement subsystem 1100 in accordance with some embodiments of the present disclosure. The measurement subsystem 1100 comprises a configuration that provides four redundancy outputs, PCBA outputs 1110, 1112, 1114, and 1116, via a plurality of sensor PCBAs 1102, 1104, 1106, and 1108. The four sensor PCBAs 1102, 1104, 1106, and 1108 are configured on a same plane over a planar surface of magnet 1118. The sensor PCBAs 1102, 1104, 1106, and 1108 comprise magnetic field sensors that are configured at specific angular positions relative to the planar surface of magnet 1118 for generating PCBA outputs 1110, 1112, 1114, and 1116, respectively. In particular, to provide a given number of redundancy outputs, an inter-PCBA sensor angular distance between inter-PCBA magnetic field sensors that don't co-exist on a same sensor PCBA and a minimum number of magnetic poles that allow for a corresponding number of magnetic field sensors to provide the given number of redundancy outputs may be determined. For example, to provide four redundancy outputs, an inter-PCBA sensor angular distance may comprise a value obtained by dividing 360 (e.g., for TMR, GMR, or Hall-effect sensors) or 180 (e.g., for AMR) over a number of magnetic poles (e.g., six) that allow four pairs of PCBA magnetic field sensors (e.g., a pair of PCBA magnetic field sensors on each of sensor PCBAs 1102, 1104, 1106, and 1108) to be configured in accordance with the inter-PCBA sensor angular distance on the magnet 1118 without exceeding a full rotation of 360 degrees.

An intra-PCBA sensor angular distance between intra-PCBA magnetic field sensors that co-exist on a same sensor PCBA may be such a distance that provides a desired phase shift between signals generated by the intra-PCBA sensors. For example, a PCBA output (of the PCBA outputs 1110, 1112, 1114, and 1116) may comprise sine and cosine waves that correspond to an intra-PCBA sensor angular distance of a pair of intra-PCBA magnetic field sensors of a sensor PCBA (e.g., sensor PCBAs 1102, 1104, 1106, and 1108). As depicted, sensor PCBA 1102 comprises magnetic field sensors at angular positions 0 and 30 that are configured to generate a corresponding pair of sinusoidal voltage signals comprising PCBA output 1110, sensor PCBA 1104 comprises magnetic field sensors at angular positions 90 and 120 are configured to generate a corresponding pair of sinusoidal voltage signals comprising PCBA output 1112, sensor PCBA 1106 comprises magnetic field sensors at angular positions 180 and 210 are configured to generate a corresponding pair of sinusoidal voltage signals comprising PCBA output 1114, and sensor PCBA 1108 comprises magnetic field sensors at angular positions 270 and 300 are configured to generate a corresponding pair of sinusoidal voltage signals comprising PCBA output 1116.

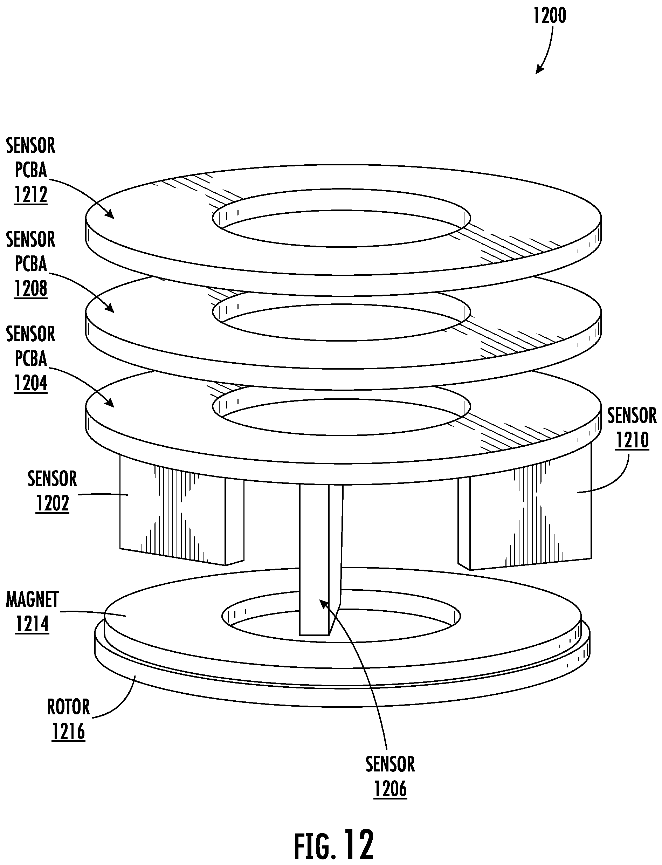

FIG. 12 is a perspective view of an example three sensor tandem redundancy configuration of a measurement subsystem 1200 in accordance with some embodiments of the present disclosure. The measurement subsystem 1200 comprises sensor PCBAs 1204, 1208, and 1212 that are axial stacked in a vertical configuration. Each of the sensor PCBAs 1204, 1208, and 1212 comprises an annulus form factor and may be identical, substantially similar, or different in size from one another. The measurement subsystem 1200 further comprises sensors 1202, 1206, and 1210 comprising magnetic field sensors that are configured vertically in one of various rotational orientations over a magnet 1214. The magnet 1214 may be mounted on a rotor 1216 and comprise a plurality of magnetic poles that are oriented in a plurality of radial spiral shapes such that a rotation of rotor 1215 causes variance in one or more magnetic fields that are induced by the plurality of magnetic poles on the sensors 1202, 1206, and 1210. The sensors 1202, 1206, and 1210 may generate individual redundancy sensor outputs (e.g., sinusoidal voltage signals) that are provided and/or transmitted to the sensor PCBAs 1204, 1208, and 1212, respectively.

It is to be understood that the disclosure is not to be limited to the specific embodiments disclosed, and that modifications and other embodiments are intended to be included within the scope of the appended claims. Although specific terms are employed herein, they are used in a generic and descriptive sense only and not for purposes of limitation, unless described otherwise.

## Claims

1. A sensor assembly comprising:
a printed circuit board assembly (PCBA) housing that is configured horizontally or in parallel with a planar surface of a magnet,
the magnet comprising a plurality of magnetic poles that are oriented in a plurality of radial spiral shapes,
the PCBA housing comprising a PCBA that is deposed within a cavity of the PCBA housing,
the PCBA comprising a pair of magnetic field sensors that (i) are oriented horizontally with respect to the planar surface of the magnet and (ii) comprises a first magnetic field sensor of the pair of magnetic field sensors that is configured a predetermined distance from a second magnetic field sensor of the pair of magnetic field sensors, wherein the pair of magnetic field sensors are configured to generate a respective pair of electrical signals that comprise (i) a phase-shift between the respective pair of electrical signals and (ii) sine and cosine waves based on a number of magnetic poles of the magnet.

2. The sensor assembly of claim 1, wherein the plurality of radial spiral shapes provides variance in one or more magnetic fields that are induced by the plurality of magnetic poles on the pair of magnetic field sensors upon causing a rotational displacement between the plurality of magnetic poles and the pair of magnetic field sensors.

3. The sensor assembly of claim **1,** wherein (i) the respective pair of electrical signals comprise oscillating patterns that comprise sine or cosine waves and (ii) the sine or cosine waves are representative of a position of the magnet or relative to the magnet.

4. A measurement subsystem comprising:
one or more printed circuit board assemblies (PCBAs) that are positioned horizontally or in parallel with a planar surface of a magnet,
a PCBA of the one or more PCBAs comprising a first magnetic field sensor and a second magnetic field sensor that are configured to (i) detect or measure one or more magnetic fields in either a radial or tangential direction with respect to the planar surface of the magnet and (ii) generate a first electrical signal and a second electrical signal based on the one or more magnetic fields.

5. The measurement subsystem of claim 4, wherein the first magnetic field sensor is configured at a predetermined angular distance from the second magnetic field sensor.

6. The measurement subsystem of claim 4, wherein the first magnetic field sensor and the second magnetic field sensor are configured on the PCBA such that the first electrical signal and the second electrical signal comprise a phase-shift between the first electrical signal and the second electrical signal and that the first electrical signal and the second electrical signal comprise sine and cosine waves based on a number of magnetic poles of the magnet.

7. The measurement subsystem of claim 4, wherein the magnet comprises at least a north magnetic pole track and a south magnetic pole track that are oriented in respective radial spiral shapes.

8. The measurement subsystem of claim 7, wherein the respective radial spiral shapes cause a rotating magnetic field in sine and cosine waveform that comprise voltage outputs at the first magnetic field sensor and the second magnetic field sensor based on rotational displacement between (i) the north magnetic pole track and the south magnetic pole track and (ii) the first magnetic field sensor and the second magnetic field sensor about a common axis.

9. The measurement subsystem of claim 8, wherein the rotational displacement is caused by rotating either the magnet or the PCBA.

10. The measurement subsystem of claim 7, wherein the first electrical signal and the second electrical signal comprise respective sine and cosine patterns based on the respective radial spiral shapes.

11. The measurement subsystem of claim 4, wherein the first magnetic field sensor and the second magnetic field sensor are configured to generate the first electrical signal and the second electrical signal based on a rotational position of the magnet with respect to the first magnetic field sensor and the second magnetic field sensor.

12. The measurement subsystem of claim 4, wherein the first electrical signal and the second electrical signal are associated with an angle, speed, direction, or linear position.

13. The measurement subsystem of claim 4, wherein at least one of the first magnetic field sensor or the second magnetic field sensor comprises a magneto-resistive (MR) Wheatstone bridge circuit.

14. The measurement subsystem of claim 13, wherein the MR Wheatstone bridge circuit comprises two interleaved or overlaid MR Wheatstone bridges that are associated with respective ones of the first magnetic field sensor and the second magnetic field sensor.

15. The measurement subsystem of claim 4, wherein the first magnetic field sensor and the second magnetic field sensor are oriented either horizontally or vertically with respect to the planar surface of the magnet.
